# EUROPEAN PATENT APPLICATION

(11) **EP 3 122 162 A1**
(43) Date of publication of application: **25.01.2017**
(21) Application number: 16020256.0
(22) Date of filing: 30.06.2016
(51) Int. Cl.: H05K 1/02, H01P 3/08, H05K 3/46

(54) **FLEXIBLE WIRING BOARD**

(30) Priority: 22.07.2015 JP 2015145121
(71) Applicant: Hosiden Corporation, Yao-shi, Osaka 581-0071 (JP)
(72) Inventor: KATO, Ryuhei, Yao-shi, Osaka 581-0071 (JP); KONDO, Hayato, Yao-shi, Osaka 581-0071 (JP)
(74) Representative: Beresford Crump LLP

(57) **Abstract**

The invention provides a flexible wiring board that can reliably exhibit adequate and sufficient transmission characteristics. A flexible wiring board F includes a base 100 being an elongate dielectric, a cover 200 being a dielectric, a signal conductor 300, and a ground conductor 400. The cover 200 is fixed on at least one of a first face 101 and a second face 102 of the base 100 and covers a portion in a lengthwise direction of the at least one of the faces 101 or 102. The signal conductor 300 is provided at the base 100 and extends in the lengthwise direction. The signal conductor 300 includes a first portion 310 and a second portion 320. The ground conductor 400 is provided at the base 100 and extends in parallel with and in spaced relation to the signal conductor 300. The ground conductor 400 includes a first portion 410 and a second portion 420. The first portion 310 and the first portion 410 are covered by the cover 200, and the second portion 320 and the second portion 420 are not covered by the cover 200. A part of the second portion 420 that exists in a second region of the second portion 320 of the base 100 is smaller in area than a part of a first region of the first portion 410 that exists in a first region of the first portion 310 of the base 100.

## Description

### Technical Field

The invention relates to flexible wiring boards.

### Background Art

JP 2007-123740 A and WO 2012/073591 A disclose conventional flexible wiring boards. Each conventional flexible wiring boards include an insulative base, a signal conductor, and a ground conductor. The signal conductor and the ground conductor are provided on the base to form a microstrip line.

### Summary of Invention

### Technical Problem

Each flexible wiring board above is used in an electronic apparatus to connect between two electronic components. Contact of the flexible wiring board with another component (e.g. a terminal of an electronic component, a metal shell of an electronic component, etc.) in the electronic apparatus disturbs the characteristic impedance of the signal conductor and/or the ground conductor. This results in degradation of transmission characteristics of the flexible wiring board.

The invention is conceived in light of the above circumstances and provides a flexible wiring board that can reliably exhibit adequate and sufficient transmission characteristics.

### Solution to Problem

A flexible wiring board according to an aspect of the invention includes a base, at least one cover, at least one signal conductor, and at least one ground conductor. The base is an elongate flexible dielectric including a first portion and a second portion. The first portion is a portion in a lengthwise direction of the base and has a first face and a second face opposite to each other in a thickness direction of the base. The second portion is another portion in the lengthwise direction of the base. The at least one cover is of dielectric material being lower in permittivity than the base. The at least one cover is fixed on and covers at least a part of one of the first and second faces of the first portion of the base. The signal conductor is provided in or on the base and extends in the lengthwise direction and includes a first portion covered by the at least one cover and a second portion not covered by the at least one cover. The ground conductor is provided in or on the base and extends in parallel with and in spaced relation to the signal conductor. The ground conductor includes a first portion covered by the at least one cover and a second portion not covered by the at least one cover. A part of the second portion of the ground conductor situated in a second region of the second portion of the base is smaller in area than a part of the first portion of the ground conductor situated in a first region of the first portion of the base, the first region being equal in area to the second region.

The flexible wiring board of this aspect is configured to suppress degradation of transmission characteristics. Particularly, the cover covers a portion of at least one of the first and second faces of the base, reducing the possibility that the base comes into contact with another component. This reduces possibility of degradation of transmission characteristics of the flexible wiring board due to contact of the base with another component. Second, the signal conductor includes the first portion covered by the cover and the second portion not covered by the cover, which should result in difference in impedance between the first and second portions of the signal conductor. However, the ground conductor is configured such that the part of the second portion that exists in the second region of the base is smaller in area than the part of the first portion that exists in the first region of the base. This increases the impedance of the second portion of the signal conductor, i.e. reduces the difference in impedance between the first and second portions of the signal conductor. Hence, degradation of transmission characteristics is suppressed in the flexible wiring board.

There are a number of alternative means to make the second portion of the ground conductor smaller in unit area than the first portion of the ground conductor. An example of such a means is to differentiate the dimensions in the widthwise direction of the first and second portion of the ground conductor. More particularly, the second portion or portions of the ground conductor may be smaller in widthwise dimension than the first portion or portions of the ground conductor.

The ground conductor may have a plurality of openings arranged at intervals along a part of the ground conductor which is opposite to the signal conductor. In this case, at least one of the openings located in the second portion of the ground conductor may be larger in size or area than at least one of the openings located in the first portion of the ground conductor. Alternatively, the openings located in the second portion of the ground conductor may be arranged at shorter intervals (i.e. closer together) than the openings located in the first portion of the ground conductor. The openings may be of the same shape, or may be of different shapes, dimensions or aspect ratio. In these aspects of the invention, to differentiate the outer sizes of the openings located in the second portion of the ground conductor and those located in the first portion of the ground conductor, or to differentiate the intervals of the openings located in the second portion of the ground conductor and those located in the first portion of the ground conductor serve as some other example means to make the particular part of the second portion of the ground conductor in the second region smaller in area than the particular part of the first portion of the ground conductor in the first region.

The ground conductor may have at least one opening only in a second portion thereof. In this aspect of the invention, to provide an opening in the second portion of the ground conductor is still another example of a means to make the second portion of the ground conductor smaller in unit area than the first portion of the ground conductor.

There may be provided two ground conductors, between which the signal conductor, or a plurality of the signal conductors, may be disposed.

### Brief Description of Drawings

Fig. 1A is a front, top, right side perspective view of a flexible wiring board of an embodiment of the invention.
Fig. 1B is a back, bottom, left side perspective view of the flexible wiring board.
Fig. 1C is a front, top, right side perspective view of the flexible wiring board, with the second portions of the base in a bent state.
Fig. 2A is a cross sectional view of the flexible wiring board, taken along line 2A-2A of Fig. 1A.
Fig. 2B is a cross sectional view of the flexible wiring board, taken along line 2B-2B of Fig. 1A.
Fig. 2C is a cross sectional view of the flexible wiring board, taken along line 2C-2C of Fig. 1A.
Fig. 2D is a cross sectional view of the flexible wiring board, taken along line 2D-2D of Fig. 1A.
Fig. 2E is a cross sectional view of the flexible wiring board, taken along line 2E-2E of Fig. 1A.
Fig. 2F is a cross sectional view of the flexible wiring board, taken along line 2F-2F of Fig. 1A.
Fig. 3A is a front, top, right side perspective view of the base, the signal conductor, and the ground conductor of the flexible wiring board, with the base illustrated in dot-dot-dash lines.
Fig. 3B is a back, bottom, left side perspective view of the base, the signal conductor, and the ground conductor of the flexible wiring board, with the base illustrated in dot-dot-dash lines.
Fig. 4A is a plan view of a base, a signal conductor, and a ground conductor of a flexible wiring board of another embodiment, with the base illustrated in dot-dot-dash lines and the ground conductor having a different configuration.
Fig. 4B is a bottom view of the base, the signal conductor, and the ground conductor of the flexible wiring board, with the base illustrated in dot-dot-dash lines.
Fig. 5 is a cross sectional view of a variant flexible wiring board.
Fig. 6A is a cross sectional view of another variant flexible wiring board.
Fig. 6B is a cross sectional view of still another variant flexible wiring board.

In the brief description of the drawings above and the description of embodiments which follows, relative spatial terms such as "upper", "lower", "top", "bottom", "left", "right", "front", "rear", etc., are used for the convenience of the skilled reader and refer to the orientation of the flexible wiring board and their constituent parts as depicted in the drawings. No limitation is intended by use of these terms, either in use of the invention, during its manufacture, shipment, custody, or sale, or during assembly of its constituent parts or when incorporated into or combined with other apparatus.

### Description of Embodiments

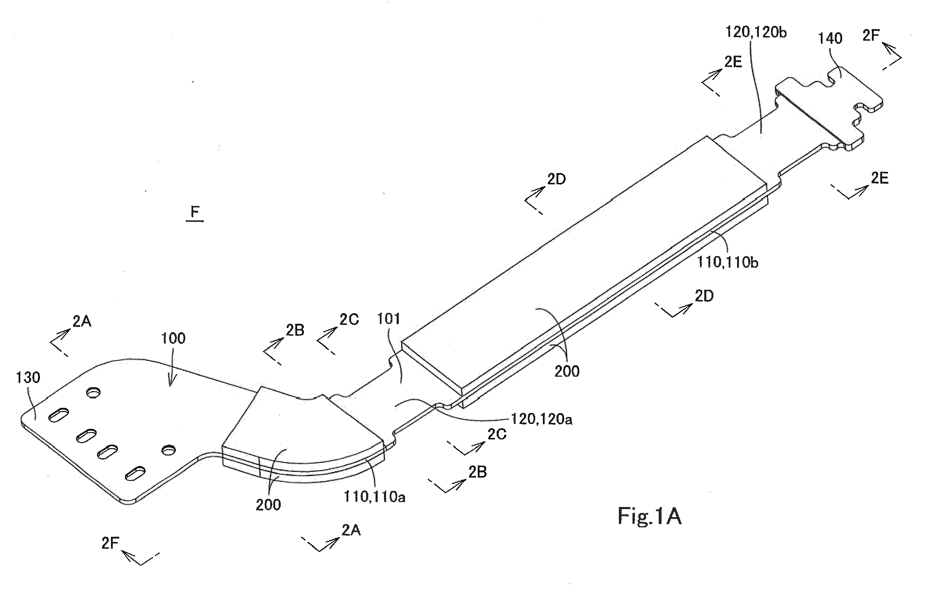

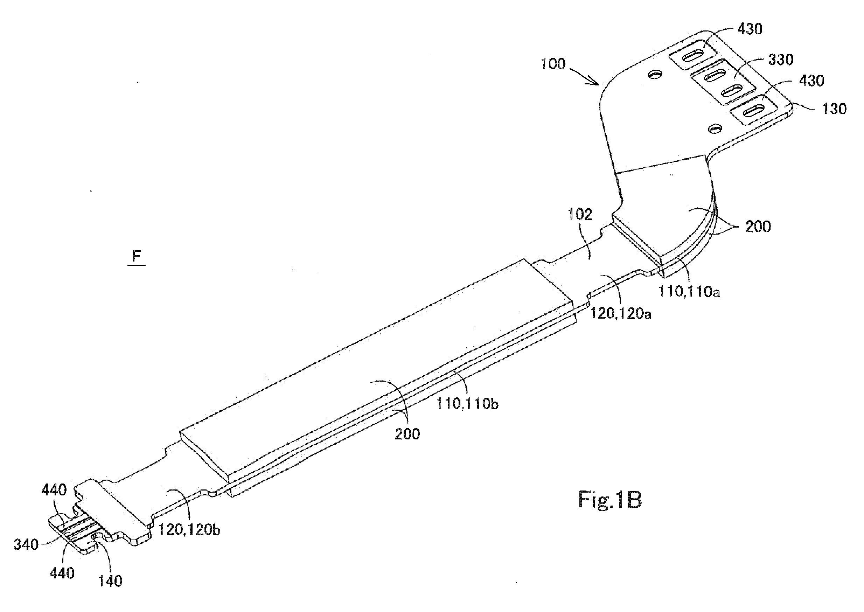

Embodiments of the invention will be hereinafter described with reference to Figs. 1A to 4B. The flexible wiring board F of each embodiment includes a base 100, at least one cover 200, at least one signal conductor 300, and at least one ground conductor 400. For convenience of description, the lengthwise, widthwise, and thickness directions of the base 100 will be referred to as first, second, and third directions, respectively. The first direction corresponds to the lengthwise direction defined in the claims. The second direction crosses the first direction and corresponds to the widthwise direction defined in the claims. The third direction is perpendicular to the first and second directions and corresponds to the thickness direction defined in the claims.

The base 100 is an elongate flexible dielectric. The base 100 has a first face 101 and a second face 102. The first face 101 is one of the faces in the third direction of the base 100, and the second face 102 is the other face in the third direction of the base 100. In other words, the first and second faces are opposite faces of the base 100. In the embodiments as shown in Figs. 1A to 4B, the base 100 is an elongate flexible insulating board.

The at least one signal conductor 300 may be provided inside the base 100 or directly on the first face 101 of the base 100. The at least one signal conductor 300 extends along the base 100. In the embodiments of Figs. 1A to 4B, there is provided a single signal conductor 300.

The at least one ground conductor 400 may be provided inside the base 100 or directly on the second face 102 of the base 100. The ground conductor 400 extends in parallel with and in spaced relation in the third direction to the at least one signal conductor 300. The at least one ground conductor 400 is opposed to the at least one signal conductor 300 with the base 100 therebetween in the third direction. The or each ground conductor 400 is larger in second direction dimension, i.e. in width, than the or each signal conductor. It is preferable that the or each signal conductor 300 and the or each ground conductor 400 constitute a microstrip line.

The base 100 includes at least one first portion 110, at least one second portion 120, a first end portion 130, and a second end portion 140. The or each first portion 110 is a portion in the first direction of the base 100 and has a first face and a second face. The first face of the first portion 110 is one of the faces of the first portion 110 in the third direction and also a portion in the first direction (lengthwise direction) of the first face 101. The second face of the first portion 110 is the other face of the first portion 110 in the third direction and also another portion in the first direction (lengthwise direction) of the second face 102. The or each second portion 120 is a portion other than the at least one first portion 110 of the base 100 in the first direction. The second portion 120 has a first face and a second face. The first face of the second portion 120 is a face of the second portion 120 in the third direction and also another portion in the first direction (lengthwise direction) of the first face 101. The second face of the second portion 120 is the other face of the second portion 120 in the third direction and also another portion in the first direction (lengthwise direction) of the second face 102. The first end portion 130 is an end portion of the base 100 on one side in the first direction. The second end portion 140 is an end portion of the base 100 on the other side in the first direction.

The at least one cover 200 is formed of dielectric material being lower in permittivity than the base 100, and fixed on the first face and/or the second face of the at least one first portion 110 of the base 100. The or each cover 200 may be equal in first direction dimension to the or each first portion 110 of the base 100. The or each cover 200 may or may not be equal in second direction dimension to the or each first portion 110 of the base 100. The at least one cover 200 at least partially covers the or a respective first portion 110 and may entirely cover the or a respective first portion 110.

In the embodiments of Figs. 1A to 4B, the base 100 includes two first portions 110, namely a first portion 110a and a first portion 110b, and two second portions 120, namely a second portion 120a and a second portion 120b. The first portion 110a is a portion in the first direction of the base 100, and the first portion 110b is another portion in the first direction of the base 100. The first portion 110a curves in the second direction. The second portion 120a is a portion of the base 100 between the first portions 110a and 110b, and the second portion 120b is a portion of the base 100 between the first portion 110b and the second end portion 140. Four covers 200 are provided in the embodiments of Figs. 1A to 4B. Two of the four covers 200 are respectively fixed on the first and second faces of the first portion 110a, and the other two covers 200 are respectively fixed on the first and second faces of the first portion 110b. As such, each of the two first portions 110 is sandwiched by two of the covers 200.

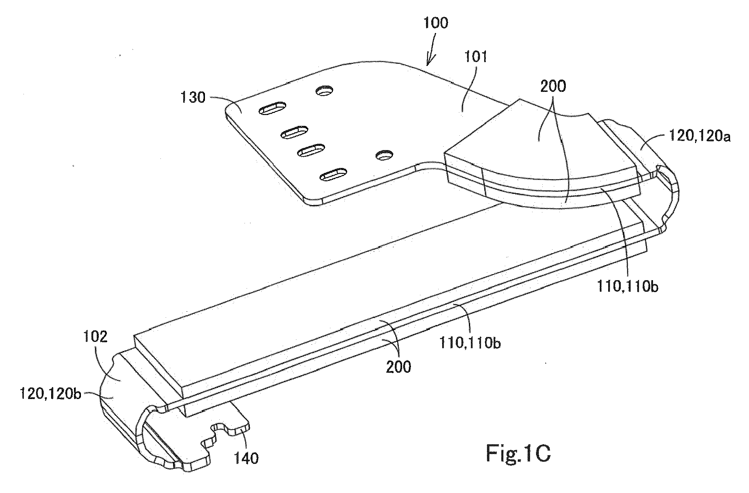

The or each cover 200 of any of the above aspects may be an insulating plate of plastic material, e.g. polyurethane foam or other plastic foam, which is relatively rigid as compared to the base 100, the material of the or each cover 200 having a permittivity lower than that of the base 100. In this case, the or each first portion 110 with a cover 200 fixed thereon is less readily curved or bent than the or each second portion 120 of the base 100 which is uncovered (see Fig. 1C). The or each cover 200 of any of the above aspects may be an insulating plastic film or the like.

The or each signal conductor 300 may include at least one first portion 310 and at least one second portion 320. The or each first portion 310 is located inside the or an associated first portion 110 or directly on the first face of the or an associated first portion 110 of the base 100. The or each first portion 310 is covered by the or an associated cover 200. The or each second portion 320 is located inside the or an associated second portion 120 or directly on the first face of the or an associated second portion 120 of the base 100. The second portion 320 is not covered by the at least one cover 200.

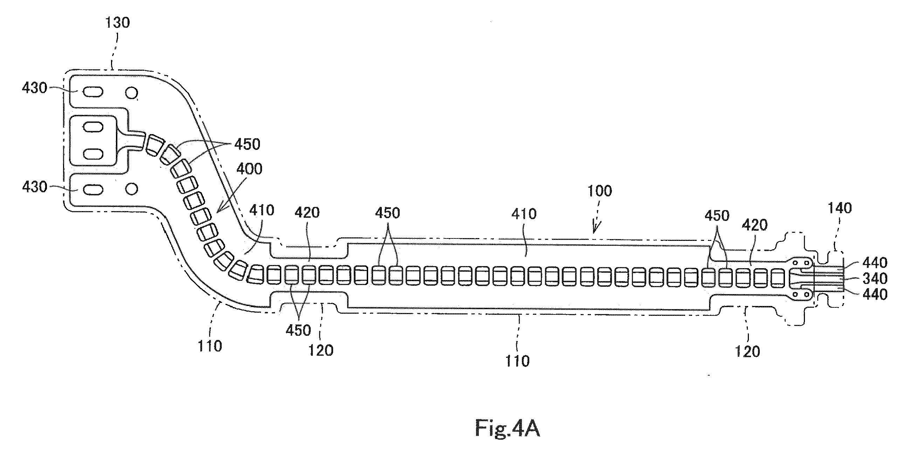

In each embodiment of Figs. 1A to 4B, a single signal conductor 300 is provided including two first portions 310, namely a first portion 310a and a first portion 310b, and two second portions 320, namely a second portion 320a and a second portion 320b. The first portion 310a is located inside the first portion 110a of the base 100, and the first portion 310b is located inside the first portion 110b of the base 100. The second portion 320a is located inside the second portion 120a of the base 100, and the second portion 320b is located inside the second portion 120b of the base 100.

The or each ground conductor 400 may include at least one first portion 410 and at least one second portion 420. The or each first portion 410 is located inside the or an associated first portion 110 or directly on the second face of the or an associated first portion 110 of the base 100, and covered by the or an associated cover 200. The or each second portion 420 is located inside the or an associated second portion 120 or directly on the second face of the or an associated second portion 120 of the base 100, and not covered by the at least one cover 200.

In each embodiment of Figs. 1A to 4B, a single ground conductor 400 is provided including two first portions 410, namely a first portion 410a and a first portion 414b, and two second portions 420, namely a second portion 420a and a second portion 420b. The first portion 410a is located inside the first portion 110a of the base 100, and the first portion 410b is located inside the first portion 110b of the base 100. The second portion 420a is located inside the second portion 120a of the base 100, and the second portion 420b is located inside the second portion 120b of the base 100.

The or each signal conductor 300 may further include a first end portion 330 and a second end portion 340. The or each first end portion 330, an end portion of the or each signal conductor 300 on the one side in the first direction, is located inside the first end portion 130 or directly on the first face of the first end portion 130 of the base 100. The or each second end portion 340, an end portion of the or each signal conductor 300 on the other side in the first direction, is located inside the second end portion 140 or directly on the first face of the second end portion 140 of the base 100. If the or each first end portion 330 is located inside the first end portion 130 and the or each second end portion 340 is located inside the second end portion 140, then the or each first end portion 330 and the or each second end portion 340 may each have a via hole for external connection, or may be exposed out of the first end portion 130 and the second end portion 140, respectively.

The or each ground conductor 400 may further include a first end portion 430 and a second end portion 440. The or each first end portion 430, an end portion of the or each ground conductor 400 on the one side in the first direction, is located inside the first end portion 130 or directly on the second face of the first end portion 130 of the base 100. The or each second end portion 440, an end portion of the or each ground conductor 400 on the other side in the first direction, is located inside the second end portion 140 or directly on the second face of the second end portion 140 of the base 100. If the or each first end portion 430 is located inside the first end portion 130 and the or each second end portion 440 is located inside the second end portion 140, then the or each first end portion 430 the or each second end portion 440 may each have a via hole for external connection, or may be exposed out of the first end portion 130 and the second end portion 140, respectively.

In each embodiment of Figs. 1A to 4B, the first end portion 330 of the signal conductor 300 is located inside the first end portion 130 of the base 100 and has a via hole for external connection. The second end portion 340 of the signal conductor 300 is exposed out of the second end portion 140, which is partially cut out, of the base 100. The first end portion 430 of the ground conductor 400 bifurcates into two tines, and these tines extend on respective sides in the second direction of the first end portion 330 of the signal conductor 300 inside the first end portion 130 of the base 100. The first end portion 430 has two via holes for external connection. The second end portion 440 of the ground conductor 400 is bifurcated into two tines, and these tines are exposed out of the second end portion 140, which is partially cut, of the base 100. The two tines of the second end portion 440 extend on respective sides in the second direction of the second end portion 340 of the signal conductor 300.

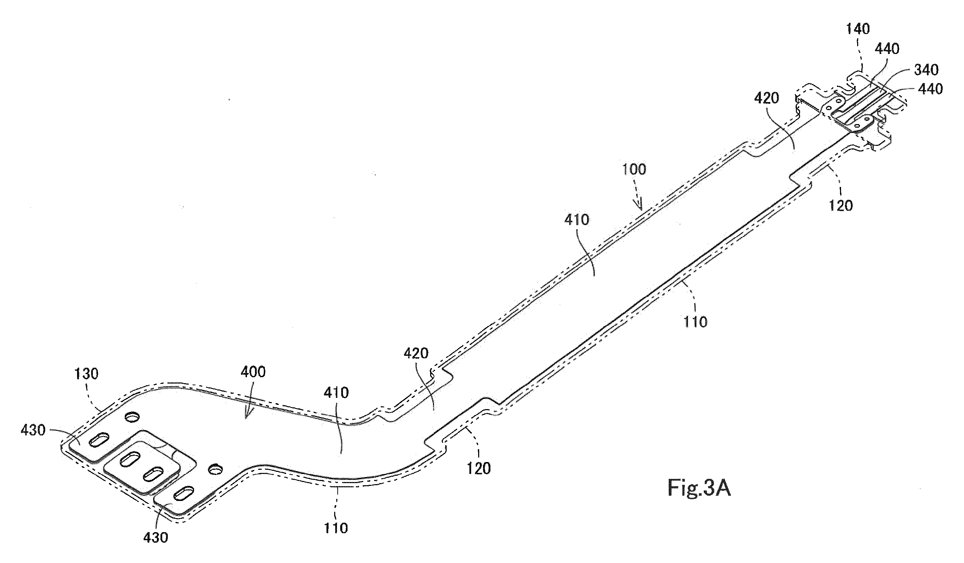

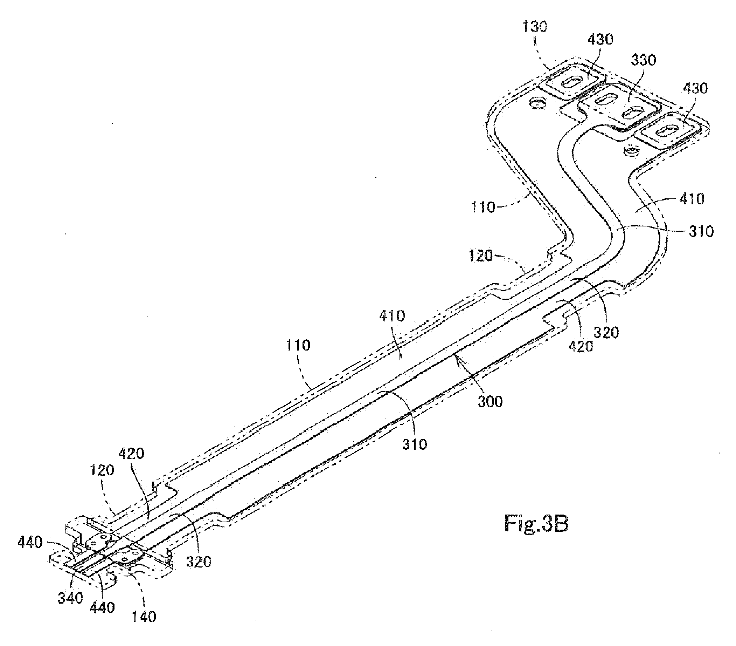

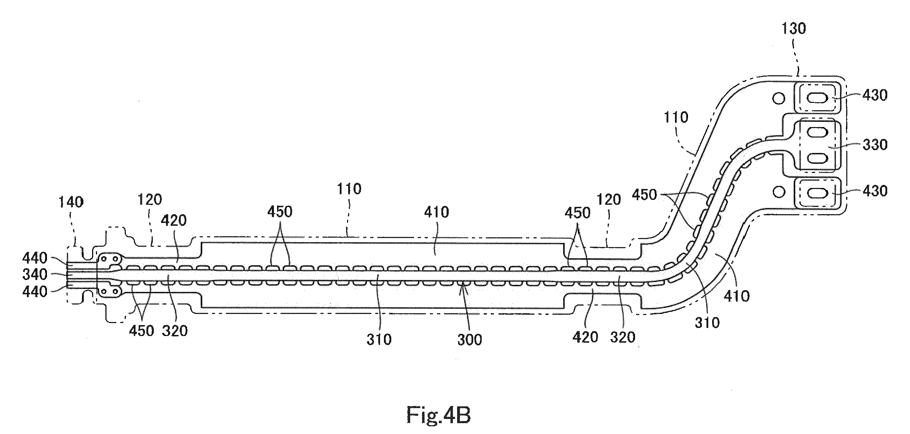

The at least one ground conductor 400 may further have a plurality of openings 450 as illustrated in Figs. 4A and 4B. The openings 450 of the ground conductor 400 may be arranged at intervals along the at least one signal conductor 300. Alternatively, the at least one ground conductor 400 may have no openings as illustrated in Figs. 3A and 3B.

It should be noted that as described above, the first portion 310 of the or each signal conductor 300 is covered by the or an associated cover 200, whereas the second portion 320 of the or each signal conductor 300 is not covered by the at least one cover 200. This should result in difference in impedance between the or each first portion 310 and the or each second portion 320. Specifically, the or each second portion 320 should be smaller in impedance than the or each first portion 310. However, it is desirable to eliminate or reduce the difference in impedance between the or each first portion 310 and the or each second portion 320 by increasing the impedance of the or each second portion 320. To this end, the or each ground conductor 400 is configured such that a particular part of the or each second portion 420 situated in a second region of the base 100 is smaller in area than a particular part of the or each first portion 410 situated in a first region of the base 100, the first and second regions of the base 100 being regions of equal area extending in a plane direction of the base 100.

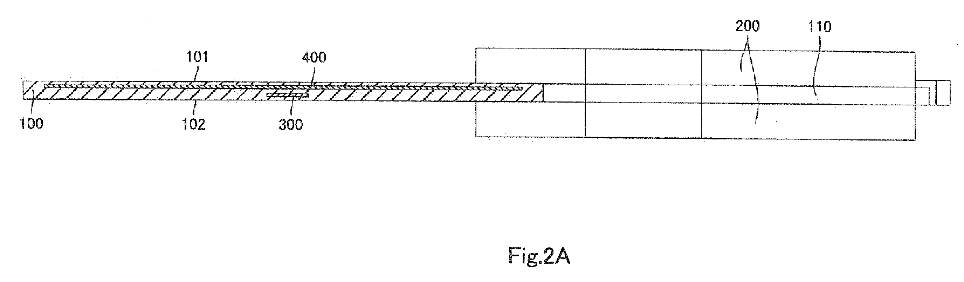

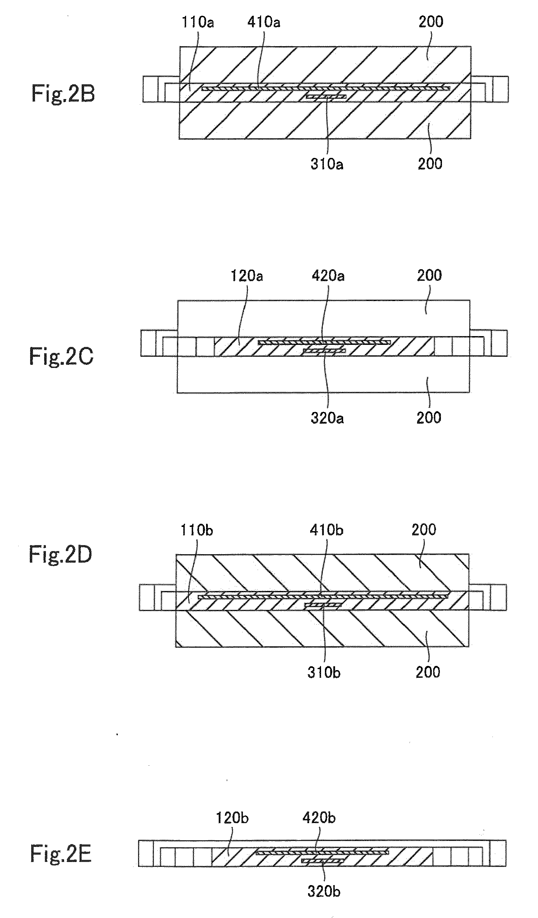

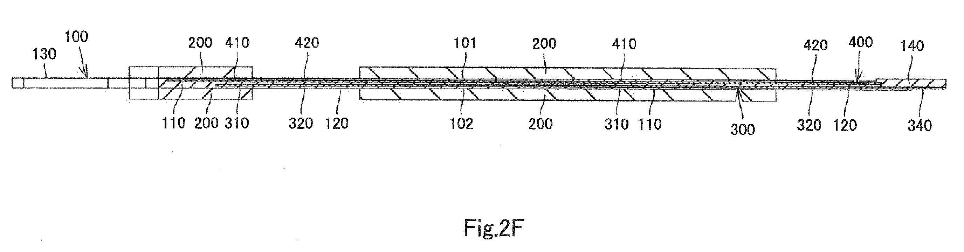

Specific means for making the particular part of the second portion 420 of the ground conductor 400 smaller in area than the particular part of the first portion 410 of the ground conductor 400 may be one of the following configurations (1) to (4), combination of (1) and (2), combination of (1) and (3), combination of (1) to (3), combination of (1) and (4), or combination of (2) and (3), but not limited thereto.
(1) The or each second portion 420 of the at least one ground conductor 400 is smaller in second direction dimension (in width) than the or each first portion 410 of the same ground conductor 400.
(2) If the at least one ground conductor 400 has the openings 450 arranged at intervals along the at least one signal conductor 300, at least one of the openings 450 located in the or each second portion 420 of the or each ground conductor 400 is larger in outer size than each opening 450 located in the or each first portion 410 of the or each ground conductor 400. In this case, it is preferable that the openings 450 excluding the enlarged one be of substantially the same outer size.
(3) If the at least one ground conductor 400 has the openings 450 arranged at intervals along the at least one signal conductor 300, the openings 450 located in the or each second portion 420 of the or each ground conductor 400 are arranged at shorter intervals than the openings 450 located in the or each first portion 410 of the or each ground conductor 400. In this case, it is preferable that the openings 450 be of substantially the same outer size.
(4) At least one opening 450 is provided only in the second portion 420 of the ground conductor 400. It should be appreciated that configuration (1) is adopted in the embodiments of Figs. 2A to 4B. In the embodiment of Figs. 4A to 4B, the ground conductor 400 has the openings 450 but does not have any of configurations (2) to (4).

In the case of adopting configuration (1), the or each second portion 120 of the base 100 can be smaller in second direction dimension (in width) than the or each first portion 110 of the base 100. The reduced size of the second portion 120 of the base 100 in the second direction facilitates curving or bending the second portion 120. In the case of adopting configuration (1), the or each second portion 120 of the base 100 may be equal in second direction dimension (in width) to the or each first portion 110 of the base 100.

The flexible wiring board F may be fabricated in the following steps. First, prepared are the base 100, the at least one signal conductor 300, and the at least one ground conductor 400. The base 100 is provided with the at least one signal conductor 300 and the at least one ground conductor 400 in parallel with and in spaced relation in the third direction to the at least one signal conductor 300. At least a part of the base 100 is situated between the at least one signal conductor 300 and the at least one ground conductor 400. Second, the at least one cover 200 is prepared and fixed directly on the first face and/or the second face of the at least one first portion 110 of the base 100. The at least one cover 200 thus covers the first portion 310 of the at least one signal conductor 300 and the first portion 410 of the at least one ground conductor 400 provided at the or an associated first portion 110. The flexible wiring board F is thus fabricated.

The flexible wiring board F described above has at least the following technical features. First, the flexible wiring board F reliably exhibits adequate and sufficient transmission characteristics for the following reasons. When the flexible wiring board F is disposed in an electronic apparatus and connects two electronic components inside the electronic apparatus, the base 100 is unlikely to come into contact with other components of the electronic apparatus. This is because the at least one cover 200 covers at least one of the first face and the second face of the at least one first portion 110 of the base 100. This arrangement thus reduces degradation of transmission characteristics of the flexible wiring board F due to contact of the base 100 with such other components. Furthermore, the or each ground conductor 400 is configured such that a part of the or each second portion 420 that exists in a second region of the base 100 is smaller in area than a part of the or each first portion 410 that exists in a first region of the base 100. This increases the impedance of the or each second portion 320 of the or each signal conductor 300, i.e. reduces the difference in impedance between the or each second portion 320 and the or each first portion 310 of the or each signal conductor 300. This contributes to suppressed degradation of transmission characteristics of the flexible wiring board F.

Second, the flexible wiring board F can be curved or bent into an intended shape. Particularly, the at least one cover 200 is fixed on the or an associated first portion 110 of the base 100, making it more difficult to curve or bend the or each first portion 110 while allowing the or each second portion 120 of the base 100 to be curved or bent. It is accordingly possible to curve or bend the flexible wiring board F at one or more intended locations by setting the at least one second portion 120 specifically to such intended locations. Further, if the or each second portion 420 of the or each ground conductor 400 is smaller in width than the or each first portion 410 of the or each ground conductor 400, it is possible to facilitate curving or bending the at least one second portion 120 by reducing the width of the at least one second portion 120 of the base 100.

It should be noted that the flexible wiring board described above is not limited to the above embodiments but can be modified in any manner within the scope of the claims. Specific modifications will be described below.

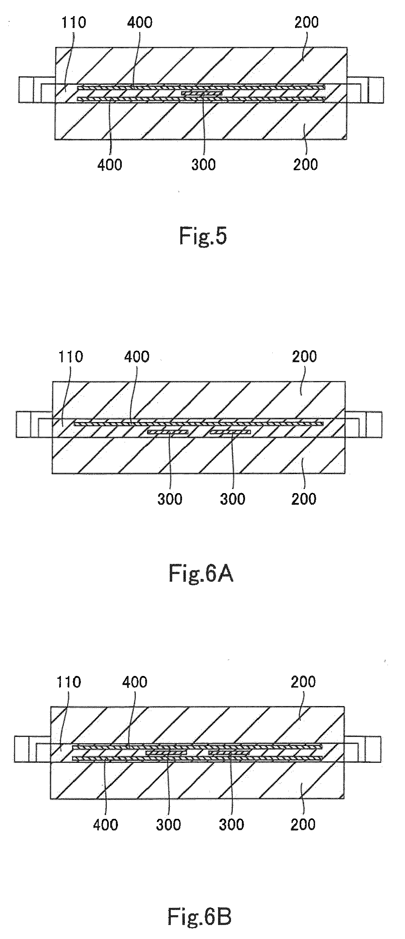

The at least one ground conductors 400 of any aspect described above may be two ground conductors 400. As shown in Fig. 5, it is preferable that one of the two ground conductors 400 be provided at the base 100 (i.e. in or on the base 100) such as to extend on the one side in the third direction relative to the signal conductor 300, in parallel with and in spaced relation to the signal conductor 300. It is also preferable that the other ground conductor 400 be provided at (i.e. within or on) the base 100 such as to extend on the other side in the third (thickness) direction relative to the signal conductor 300, in parallel with and in spaced relation to the signal conductor 300. In other words, a single signal conductor 300 is disposed between the two ground conductors 400, and the two ground conductors 400 and the signal conductor 300 constitute a stripline. In this case, the ground conductors 400, the signal conductor 300, and the base 100 can be of any of the above aspects.

The at least one signal conductor 300 of any aspect described above may be a plurality of signal conductors. For example, two signal conductors 300 of any aspect described above may be provided inside the base 100 or directly on the first face 101 such as to extend in parallel with and in spaced relation to each other in the second direction of the base 100, and the at least one ground conductor 400 of any aspect described above may be provided inside the base 100 or directly on the second face 102 of the base 100 such as to extend in parallel with and in spaced relation to the two signal conductors 300. Figs. 6A and 6B illustrate variant flexible wiring boards each including two signal conductors as described above. In the variant of Fig. 6A, a single ground conductor 400 extends in parallel with and in spaced relation to the two signal conductors 300 in the third direction. In the variant of Fig. 6B, two ground conductors 400 are provided, one of which extends on the one side in the third direction relative to the two signal conductors 300, in parallel with and in spaced relation to the two signal conductors 300. The other ground conductor 400 extends on the other side in the third direction relative to the two signal conductors 300, in parallel with and in spaced relation to the two signal conductors 300. In either variant of Figs. 6A and 6B, the at least one ground conductor 400, the signal conductors 300, and the base 100 can be of any aspect described above.

It should be appreciated that the above embodiments and variants of the flexible wiring board are described above by way of examples only. The materials, shapes, dimensions, numbers, arrangements, and other configurations of the constituents of the flexible wiring board may be modified in any manner if they can perform similar functions. The configurations of the embodiments and the variants described above may be combined in any possible manner.

### Reference Signs List

- F:: flexible wiring board
- 100:: base
101: first face
102: second face
110: first portion
120: second portion
130: first end
140: second end
- 200:: cover
- 300:: signal conductor
310: first portion
320: second portion
330: first end
340: second end
- 400:: ground conductor
410: first portion
420: second portion
430: first end
440: second end
450: opening

## Claims

1. A flexible wiring board (F) comprising:
a base (100) being an elongate flexible dielectric including a first portion (110) and a second portion (120), the first portion (110) being a portion extending in a lengthwise direction of the base and having a first face (101) and a second face (102) opposite to each other in a thickness direction of the base, the second portion (120) being another portion extending in the lengthwise direction of the base;
at least one cover (200) of dielectric material being lower in permittivity than the base, the at least one cover being fixed on and at least partially covering at least one of the first (101) and second (102) faces of the first portion (110) of the base (100);
a signal conductor (300) being provided at the base and extending in the lengthwise direction, the signal conductor including a first portion (310) covered by the at least one cover and a second portion (320) not covered by the at least one cover; and
a ground conductor (400) being provided at the base and extending in parallel with and in spaced relation to the signal conductor, the ground conductor including a first portion (410) covered by the at least one cover and a second portion (420) not covered by the at least one cover;
wherein a part of the second portion (420) of the ground conductor (400) situated in a second region of the second portion (120) of the base (100) is smaller in area than a part of the first portion (410) of the ground conductor (400) situated in a first region of the first portion (110) of the base (100), the first region being equal in area to the second region.

2. The flexible wiring board (F) according to claim 1, wherein
the second portion (420) of the ground conductor (400) is smaller in widthwise dimension than the first portion (410) of the ground conductor (400).

3. The flexible wiring board (F) according to claim 1 or claim 2, wherein
the ground conductor (400) has a plurality of openings (450) arranged at intervals along the signal conductor (300), and
at least one of the openings (450) located in the second portion (420) of the ground conductor (400) is larger in size than each opening (450) located in the first portion (420) of the ground conductor (400).

4. The flexible wiring board (F) according to any one of claims 1 to 3, wherein
the ground conductor (400) has a plurality of openings (450) arranged at intervals along the signal conductor (300), and
the openings (450) located in the second portion (420) of the ground conductor (400) are arranged at shorter intervals than the openings (450) located in the first portion (410) of the ground conductor (400).

5. The flexible wiring board (F) according to claim 1, wherein openings (450) are only formed in the second portion (420) of the ground conductor (400).

6. The flexible wiring board (F) according to any one of claims 1 to 5, wherein
the at least one cover (200) comprises a plurality of covers, and
one of the covers is fixed on the first face (101) of the first portion (110) of the base (100), and another one of the covers is fixed on the second face (102) of the first portion (110) of the base (100).

7. The flexible wiring board (F) according to any one of claims 1 to 5, wherein
the first portion (110) of the base (100) comprises a plurality of first portions (110a, 110b),
the at least one cover (200) comprises a plurality of covers, and
each cover is fixed on one of the first and second faces of an associated one of the first portions (110a, 110b) of the base.

8. The flexible wiring board (F) according to any one of claims 1 to 7, wherein
the first portion (110) of the base (100) is fixed to the at least one cover (200) such as to be relatively inflexible, as compared to the second portion (120) of the base (100) which is not fixed to a cover.

9. The flexible wiring board (F) according to any one of claims 2 to 4, wherein
the first portion (110) of the base (100) is fixed to the at least one cover (200) such as to be relatively inflexible, as compared to the second portion (120) of the base (100) which is not fixed to a cover, and
the second portion (120) of the base (100) is smaller in widthwise dimension than the first portion (110) of the base (100).

10. The flexible wiring board (F) according to any one of claims 1 to 9, wherein a first portion (110) of the base (100) curves in a widthwise direction of the base.

11. The flexible wiring board (F) according to any one of claims 1 to 5, wherein
the first portion (110) of the base (100) comprises a plurality of first portions (110a, 110b),
the at least one cover (200) comprises a plurality of covers, each cover being fixed on and at least partially covering said one of the first and second faces of an associated one of the first portions (110a, 110b) of the base, and
at least one of the first portions (110a, 110b) of the base (100) curves in a widthwise direction of the base.

12. The flexible wiring board (F) according to any one of claims 1 to 11, wherein
the ground conductor (400) comprises two ground conductors spaced from each other in the thickness direction of the base (100), and
the signal conductor (300) is disposed between the two ground conductors.

13. The flexible wiring board (F) according to any one of claims 1 to 12, wherein
the signal conductor (300) comprises a plurality of signal conductors extending in the lengthwise direction such as to be in parallel with and in spaced relation to each other in a widthwise direction of the base (100), and
the ground conductor (400) extends in parallel with and in spaced relation to the signal conductors in the thickness direction of the base (100).
